# EUROPEAN PATENT APPLICATION

(11) **EP 4 697 386 A1**
(43) Date of publication of application: **18.02.2026**
(21) Application number: 24806555.9
(22) Date of filing: 13.05.2024
(51) Int. Cl.: H01L 33/20

(54) **DISPLAY PANEL AND ELECTRONIC DEVICE**

(30) Priority: 18.05.2023 CN 202310562585
(71) Applicant: Huawei Technologies Co., Ltd., Shenzhen, Guangdong 518129 (CN)
(72) Inventor: LIU, Jinqiang, Shenzhen, Guangdong 518129 (CN); ZHANG, Li, Shenzhen, Guangdong 518129 (CN); JIANG, Fulong, Shenzhen, Guangdong 518129 (CN); WANG, Lei, Shenzhen, Guangdong 518129 (CN)
(74) Representative: Gill Jennings & Every LLP
(86) International application number: PCT/CN2024/092908
(87) International publication number: WO 2024/235204

(57) **Abstract**

A display panel and an electronic device are disclosed, and relate to the field of display technologies. The display panel includes a substrate (110), and an LED mesa (120) and a conductive spreading layer (130) that are located on the substrate (110). The LED mesa (120) includes a light-emitting surface (124), and the light-emitting surface (124) is used for emission of light from the display panel. The conductive spreading layer (130) is attached to and fully covers the light-emitting surface (124). The entire light-emitting surface (124) is in contact with the conductive spreading layer (130), the conductive spreading layer (130) is attached to the light-emitting surface (124), and there is no dielectric layer (140) between the conductive spreading layer (130) and the light-emitting surface (124). Therefore, the LED mesa (120) does not have a defect energy level formed by being in contact with the dielectric layer (140). This can maximize an area of the light-emitting surface (124) of the LED mesa (120), and improve electrical-to-optical conversion efficiency of the display panel.

## Description

This application claims priority to Chinese Patent Application No. 202310562585.5, filed with the China National Intellectual Property Administration on May 18, 2023 and entitled "DISPLAY PANEL AND ELECTRONIC DEVICE", which is incorporated herein by reference in its entirety.

### TECHNICAL FIELD

This application relates to the field of display technologies, and in particular, to a display panel and an electronic device.

### BACKGROUND

With development of display technologies, particularly development of near-eye display technologies in related fields such as virtual reality technologies and augmented reality technologies, a size of a screen of a display panel is greatly reduced, and display resolution is greatly improved.

As the size of the screen of the display panel is greatly reduced, a size of a single pixel is also reduced, and the display resolution is improved. The display panel is increasingly miniaturized and integrated.

In a current manufacturing process of a miniaturized display panel, a dielectric film is deposited on a surface of an LED mesa (a light-emitting semiconductor). In this process, a part of the dielectric film is left on the top (a light-emitting side) of the LED mesa. The left dielectric causes a decrease in a light-emitting aperture, and enables the LED mesa to have a defect energy level formed by being in contact with a dielectric layer, leading to reduction in electrical-to-optical conversion efficiency of a device.

### SUMMARY

This application provides a display panel and an electronic device. An entire light-emitting surface of the display panel is attached to a conductive spreading layer, and the light-emitting surface is not in contact with a dielectric layer, to improve electrical-to-optical conversion efficiency of the display panel.

According to a first aspect, this application provides a display panel. The display panel includes a substrate, and an LED mesa and a conductive spreading layer that are located on the substrate, where the LED mesa includes a light-emitting surface, the light-emitting surface is used for emission of light from the display panel, and the conductive spreading layer is attached to and fully covers the light-emitting surface.

In this implementation of this application, the conductive spreading layer is attached to the light-emitting surface, the entire light-emitting surface is in contact with the conductive spreading layer, there is no dielectric layer between the conductive spreading layer and the light-emitting surface, and the light-emitting surface is not in contact with the dielectric layer. In a current manufacturing process of a miniaturized display panel, a dielectric film is deposited on a surface of a semiconductor. In this process, a part of a dielectric is left on the top of an LED mesa. The left dielectric causes a decrease in a carrier injection area, and a defect energy level formed by being in contact with a dielectric layer by the LED mesa, affecting electrical-to-optical conversion efficiency of a device. In this application, the conductive spreading layer is attached to the light-emitting surface, the entire light-emitting surface is in contact with the conductive spreading layer, the light-emitting surface is not in contact with the dielectric layer, there is no dielectric layer between the conductive spreading layer and the light-emitting surface, and the LED mesa does not have the defect energy level formed by being in contact with the dielectric layer. In this manner, the carrier injection area of the LED mesa can be maximized, and electrical-to-optical conversion efficiency of the display panel can be improved.

In a possible implementation, there are a plurality of LED mesas, the plurality of LED mesas are spaced apart on the substrate, the display panel further includes a reflective structure, and the reflective structure is located between adjacent LED mesas and is configured to reflect light emitted from a side surface of the LED mesa back to the LED mesa. The reflective structure may reflect the light emitted from the side surface of the LED mesa back to the interior of the LED mesa, to avoid a problem of optical crosstalk between the adjacent LED mesas.

In a possible implementation, the display panel further includes a dielectric layer, the dielectric layer is filled between the adjacent LED mesas, the dielectric layer has a groove, and the reflective structure is located in the groove, and the groove may provide support for the reflective structure.

In a possible implementation, the display panel further includes a bonding layer, and the bonding layer is located between the LED mesa and the substrate; and
a first direction is a direction perpendicular to the substrate, a length of the reflective structure in the first direction is greater than or equal to 1/2 of a sum of lengths of the LED mesa and the bonding layer in the first direction, and/or a shortest distance between the reflective structure and the LED mesa is less than or equal to 1/2 of the sum of the lengths of the LED mesa and the bonding layer in the first direction.

In a possible implementation, an included angle between a reflective surface of the reflective structure and the substrate is greater than or equal to 80 degrees.

In a possible implementation, visible light reflectivity of the reflective structure is greater than or equal to 80%.

In a possible implementation, the reflective structure includes a plurality of reflective layers that are stacked to each other, and visible light reflectivity of at least one of the reflective structure is greater than or equal to 80%.

In a possible implementation, the display panel further includes the dielectric layer, the dielectric layer is filled between the adjacent LED mesas, and a refractive index of the dielectric layer ranges from 1.4 to 2.2.

In a possible implementation, the display panel further includes the dielectric layer, the dielectric layer is filled between the adjacent LED mesas, the dielectric layer includes a first dielectric layer and a second dielectric layer, the first dielectric layer is located between the LED mesa and the second dielectric layer, a refractive index of the first dielectric layer ranges from 1.6 to 2.2, and a refractive index of the second dielectric layer ranges from 1.4 to 1.8.

In a possible implementation, the LED mesa includes a first semiconductor layer, a multiple quantum well layer, and a second semiconductor layer that are sequentially stacked, and the first semiconductor layer is located between the multiple quantum well layer and the substrate. After receiving an electrical signal, the LED mesa may emit an optical signal.

In a possible implementation, the conductive spreading layer includes a first conductive part and a second conductive part, the first conductive part is attached to and fully covers the light-emitting surface, and the second conductive part is attached to the dielectric layer. The first conductive part is attached to and fully covers the light-emitting surface, so that the carrier injection area of the LED mesa can be maximized, and electrical-to-optical conversion efficiency of the display panel can be improved.

In a possible implementation, the display panel further includes a light-emitting structure, a part that is of the conductive spreading layer and that is attached to the light-emitting surface is the first conductive part, and the light-emitting structure is disposed on the first conductive part and is configured to change a direction of light emitted from the light-emitting surface. The light-emitting structure can modulate a light-emitting angle of the display panel, and improve electrical-to-optical conversion efficiency of the display panel.

In a possible implementation, the display panel further includes the dielectric layer, the dielectric layer is filled between the adjacent LED mesas, the dielectric layer has the groove, the light-emitting structure includes a lens, and the lens partially extends into the groove.

In a possible implementation, the light-emitting structure includes the lens, the lens is in a frustum shape, a spherical shape, or a prism shape, and an included angle between a side surface of the lens and the conductive spreading layer at a contact position is within a range of 60 degrees to 80 degrees.

In a possible implementation, the display panel further includes the bonding layer, the bonding layer is located between the LED mesa and the substrate, the first direction is a direction that is perpendicular to the substrate and in which the substrate faces the LED mesa, and a length of at least a part of the light-emitting structure on one side of the conductive spreading layer in the first direction is less than or equal to twice the sum of the lengths of the LED mesa and the bonding layer in the first direction.

According to a second aspect, this application further provides an electronic device. The electronic device includes the display panel provided in the first aspect.

### BRIEF DESCRIPTION OF DRAWINGS

FIG. 1 is a diagram of a partial structure of a display panel according to an implementation of this application;
FIG. 2 is an exploded view of a partial structure of a display panel according to this application;
FIG. 3 is a diagram of a light-emitting direction of a display panel according to this application;
FIG. 4 is a sectional view at an A-A position in FIG. 1;
FIG. 5 is a cross-sectional diagram of a pixel of a display panel according to an implementation of this application;
FIG. 6 is a diagram of a reflective structure of a display panel according to an implementation of this application;
FIG. 7 is a position diagram of a groove structure of a display panel according to an implementation of this application;
FIG. 8 is a three-dimensional shape diagram of a groove structure of a display panel according to an implementation of this application;
FIG. 9 is a diagram of a size of a reflective structure of a display panel according to an implementation of this application;
FIG. 10 is a diagram of a cross-sectional shape of a reflective structure of a display panel according to an implementation of this application;
FIG. 11 is a diagram of a two-layer reflective structure of a display panel according to an implementation of this application;
FIG. 12 is a diagram of a display panel with a light-emitting structure according to an implementation of this application;
FIG. 13 is a diagram of shapes of different light-emitting structures according to an implementation of this application;
FIG. 14 is a diagram of a light-emitting structure extending into a groove according to an implementation of this application;
FIG. 15 is a diagram of a light-emitting structure that is a Bragg reflector according to an implementation of this application;
FIG. 16 is a diagram of a light-emitting structure that is a nanopillar array according to an implementation of this application;
FIG. 17 is a diagram of a projection of a nanopillar array on a conductive spreading layer according to an implementation of this application;
FIG. 18 is a diagram of different shapes of a nanopillar according to an implementation of this application;
FIG. 19 is a diagram of a rough structure of a light-emitting surface according to an implementation of this application;
FIG. 20 is a diagram of a display panel preparation method according to an implementation of this application; and
FIG. 21 is a diagram of a display panel preparation process according to an implementation of this application.

### DESCRIPTION OF EMBODIMENTS

The following describes embodiments of this application with reference to accompanying drawings in embodiments of this application.

For ease of understanding, the following first describes English abbreviations and related technical terms in embodiments of this application.

It should be noted that described embodiments are merely some rather than all of embodiments of this application. All other embodiments obtained by a person of ordinary skill in the art based on embodiments of this application without creative efforts shall fall within the protection scope of this application.

Terms used in embodiments of this application are merely for describing specific embodiments, but are not intended to limit this application. The terms "a", "said" and "the" of singular forms used in embodiments and the appended claims of this application are also intended to include plural forms, unless otherwise specified in the context clearly.

It should be understood that the term "and/or" used in this specification describes only a same field for describing associated objects, and indicates that three relationships may exist. For example, A and/or B may indicate the following three cases: Only A exists, both A and B exist, and only B exists. In addition, the character "/" in this specification generally indicates an "or" relationship between the associated objects.

It should be understood that "first", "second", and the like used in this application are merely used for distinguishing and description, but cannot be understood as an indication or implication of relative importance or an indication or implication of a sequence.

In descriptions of this application, orientations or position relationships indicated by the terms "center", "upper", "lower", "front", "rear", "left", "right", "vertical", "horizontal", "top", "bottom", "inner", "outer", and the like are based on orientations or position relationships shown in the accompanying drawings, and are merely intended for ease of describing this application and simplifying descriptions, instead of indicating or implying that a specified apparatus or element needs to have a specific orientation, and be constructed and operated in the specific orientation. Therefore, this cannot be understood as a limitation on this application.

In descriptions of this application, it should be noted that unless otherwise expressly specified and limited, terms "installation", "interconnection", and "connection" should be understood in a broad sense, for example, may be a fixed connection, a detachable connection, a pressing connection, or an integral connection. A person of ordinary skill in the art may understand specific meanings of the foregoing terms in this application based on specific cases.

In this application, "within a range of ..." is used, except when it is separately specified that no end value is included, end values at both ends of the range are included by default. For example, within a range from 1 to 5, two values 1 and 5 are included.

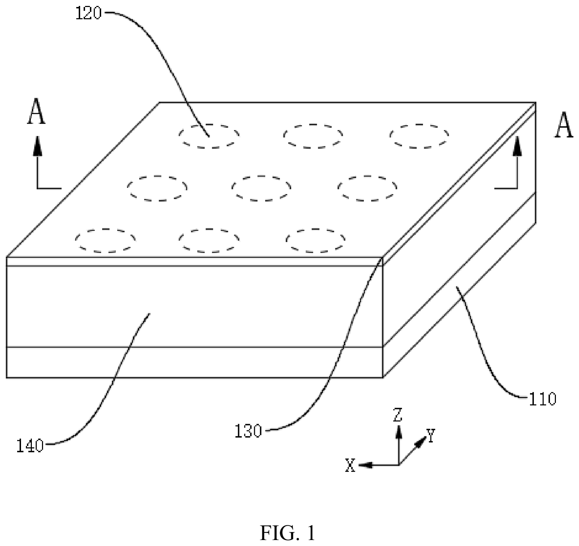

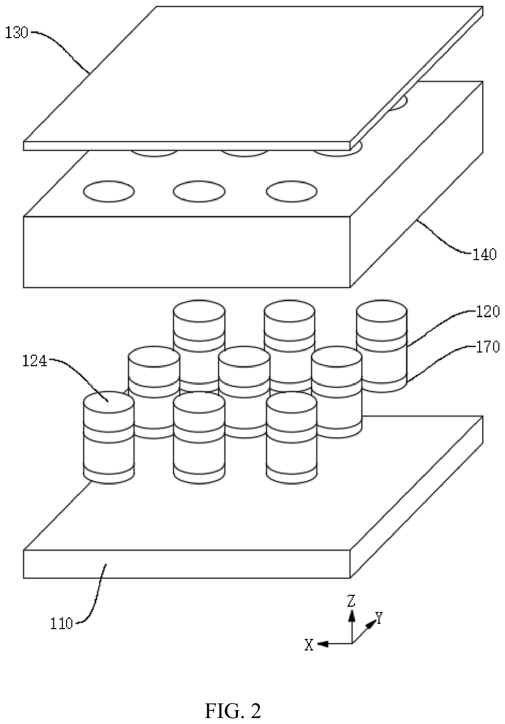

This application provides a display panel. As shown in FIG. 1 and FIG. 2, the display panel provided in implementations of this application includes a substrate 110, a bonding layer 170, an LED mesa 120, a dielectric layer 140, and a conductive spreading layer 130.

In implementations of this application, the substrate 110 may be a structure like a drive backplane or a substrate. The substrate 110 serves as a base of the display panel to support structures such as the bonding layer 170, the LED mesa 120, the dielectric layer 140, and the conductive spreading layer 130 that are disposed on the substrate 110. The substrate 110 may provide an installation platform for components such as the LED mesa 120.

The substrate 110 may be provided with a circuit layer. The circuit layer may provide an electrical signal for the LED mesa 120 located on the substrate 110, and the LED mesa 120 may receive the electrical signal sent by the circuit layer and emit light.

As shown in FIG. 2, the LED mesa 120 is in a columnar shape, and the LED mesa 120 is disposed on the substrate 110 and protrudes from a side of the substrate 110 in a Z direction. The LED mesa 120 may include a first semiconductor layer 121, a multiple quantum well layer 122, and a second semiconductor layer 123 that are sequentially stacked. The LED mesa 120 includes but is not limited to only the first semiconductor layer 121, the multiple quantum well layer 122, and the second semiconductor layer 123. A side surface that is of the second semiconductor layer 123 and that is away from the substrate 110 is a light-emitting surface 124. The first semiconductor layer 121 and the second semiconductor layer 123 are semiconductor materials of different doping types. The first semiconductor layer 121 may be a P-type semiconductor, and the second semiconductor layer 123 may be an N-type semiconductor. Alternatively, the first semiconductor layer 121 may be an N-type semiconductor, and the second semiconductor layer 123 may be a P-type semiconductor. When the LED is forward biased, electrons and holes in the first semiconductor layer 121 and the second semiconductor layer 123 are transported to the multiple quantum well layer 122 under action of an external electric field, thereby improving light-emitting efficiency.

The bonding layer 170 is disposed between the LED mesa 120 and the substrate 110 to connect the LED mesa 120 and the substrate 110, so as to implement a fixed connection between the LED mesa 120 and the substrate 110, and not to damage structures of the substrate 110 and the LED mesa 120. The bonding layer 170 may be a conductive material or a non-conductive material. For example, the conductive material may be one or more of gold, tin, indium, copper, titanium, nickel, aluminum, platinum, or tantalum, to ensure that an electrical signal on the substrate 110 can be transmitted to the LED mesa 120 through the bonding layer 170, so as to implement electrical-to-optical conversion of the display panel. The non-conductive material may be one or more of polyimide, polydimethylsiloxane, photoresist, hydrogen silsesquioxane, and divinylsiloxane-bis-benzocyclobutene. Alternatively, the non-conductive material may be a metal oxide or a metal nitride, for example, one or more of aluminum oxide, aluminum nitride, titanium oxide, and titanium nitride.

In implementations of this application, the dielectric layer 140 is located on a side of the LED mesa 120. As shown in FIG. 2, a plurality of LED mesas 120 may be disposed on the display panel, and the plurality of LED mesas 120 are arranged in a matrix on the substrate 110. The dielectric layer 140 may be filled between at least two adjacent LED mesas 120, to support the LED mesas 120 and prevent the LED mesas 120 from toppling in any direction on an XY plane. The dielectric layer 140 may be prepared by using a thin film deposition process. A thickness of a deposited thin film may range from 5 nanometers to 5000 nanometers, and a deposition medium material may be at least one of SiO₂, Al₂O₃, SiNₓ, ZrO₃, HfO₂, TiO₂, AlN, SiON, and ZnO₂.

The conductive spreading layer 130 is disposed on a side surface of the LED mesa 120 in the Z direction (located on the side surface of the LED mesa 120 in the Z direction), and at least a part of the conductive spreading layer 130 is located on a side that is of the LED mesa 120 and that is away from the substrate 110. A part of the conductive spreading layer 130 is located on a side of the dielectric layer 140 in the Z direction, and the other part of the conductive spreading layer 130 is located on the side of the LED mesa 120 in the Z direction.

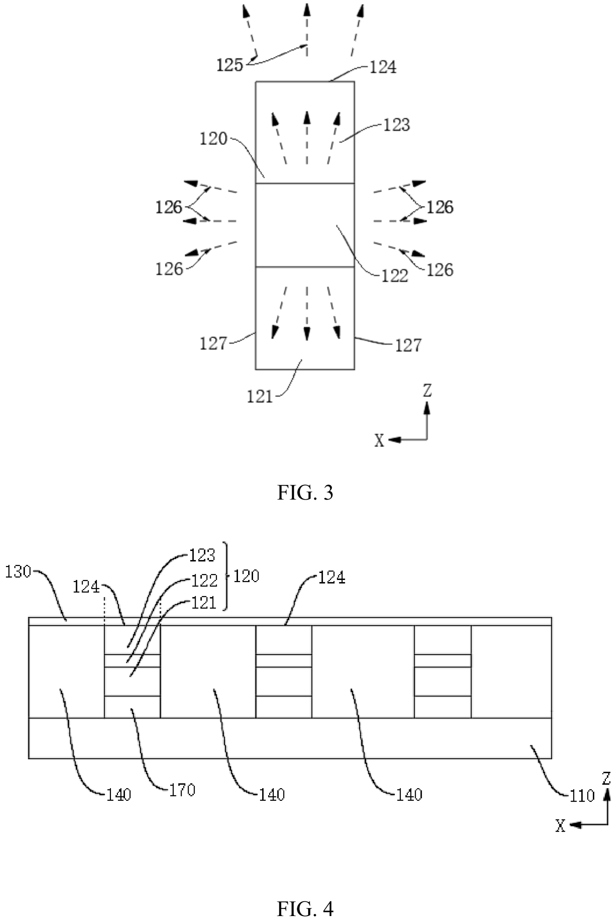

When the display panel operates, the circuit layer on the substrate 110 sends the electrical signal to the LED mesa 120, and the LED mesa 120 emits the light after receiving the electrical signal. The LED mesa 120 of the columnar shape emits light in a plurality of directions. As shown in FIG. 3, the LED mesa 120 includes the first semiconductor layer 121, the multiple quantum well layer 122, and the second semiconductor layer 123. The light emitted by the LED mesa 120 is emitted by the multiple quantum well layer 122. The LED mesa 120 emits two parts of light. One part of the light is first emitted light 125 in the Z direction, and the other part of the light is second emitted light 126 in another direction (a lateral direction of the LED mesa 120 of the columnar shape). The first emitted light 125 is main emitted light of the LED mesa 120, and the second emitted light 126 enters the dielectric layer 140, causing a loss of light energy.

In most cases, in a light-emitting device like the display panel, the first emitted light 125 is light energy mainly used. Higher light energy of the first emitted light 125 emitted by the LED mesa 120 in the Z direction indicates higher electrical-to-optical conversion efficiency of the display panel. In implementations of this application, the light-emitting surface 124 of the LED mesa 120 is a surface used to emit light emitted by the display panel. In this implementation, a light-emitting direction of the display panel is the Z direction, and the side surface that is the LED mesa 120 and that is away from the substrate 110 is defined as the light-emitting surface 124. The light-emitting surface 124 is a side surface of the LED mesa 120 in the Z direction. Greater light-emitting energy of the light-emitting surface 124 indicates higher electrical-to-optical conversion efficiency of the display panel. It may be understood that both a top surface (a top surface on a side in the Z direction) and a side surface (a side surface extending in a circumferential direction of the Z direction) of the LED mesa 120 are light-emitting surfaces. In this application, a surface that can emit the first emitted light 125 in the Z direction and that is of the LED mesa 120 is defined as the light-emitting surface 124 (refer to a partial surface of the LED mesa 120 between dashed lines in FIG. 4). Light emitted on the light-emitting surface 124 may be emitted in the Z direction or may be scattered around. The LED mesa 120 may be cylindrical, and the light-emitting surface 124 and a side surface 127 (refer to FIG. 3) are two surfaces. In an implementation, the light-emitting surface 124 and the side surface 127 may alternatively be smoothly transitioned. In this case, the light-emitting surface 124 and the side surface 127 may be two parts of an entire surface.

In this implementation, as shown in FIG. 4, the conductive spreading layer 130 fully covers the light-emitting surface 124, and the conductive spreading layer 130 is attached to the light-emitting surface 124. That the conductive spreading layer 130 fully covers the light-emitting surface 124 means that there is no dielectric layer 140 between the conductive spreading layer 130 and the light-emitting surface 124, the dielectric layer 140 is not in contact with the light-emitting surface 124, and the dielectric layer 140 and the light-emitting surface 124 are separated.

As shown in FIG. 4, the dielectric layer 140 is in contact with only the side surface 127 of the LED mesa 120, and the dielectric layer 140 does not exist between the conductive spreading layer 130 and the light-emitting surface 124. The conductive spreading layer 130 is attached to the light-emitting surface 124, and the light-emitting surface 124 is not in contact with the dielectric layer 140. The conductive spreading layer 130 fully covers the light-emitting surface 124, so that no energy level defect exists between the conductive spreading layer 130 and the light-emitting surface 124. In addition, a carrier injection area of the light-emitting surface 124 of the LED mesa 120 is increased, to increase electrical-to-optical conversion efficiency of the display panel.

In a manufacturing process of a miniaturized display panel in a conventional technology, a dielectric film is deposited on a surface of a semiconductor. In this process, a part of a dielectric is left on the top of an LED mesa 120. The left dielectric may cover a part of a light-emitting surface 124, causing a decrease in a carrier injection area, and a defect energy level formed by being in contact with a dielectric layer 140 by the LED mesa 120, and affecting electrical-to-optical conversion efficiency of a device.

In a possible implementation, before the conductive spreading layer 130 is prepared, the dielectric layer 140 on the light-emitting surface 124 may be processed according to a method like a chemical or mechanical method, to remove the dielectric layer 140 covering the light-emitting surface 124, so that the dielectric layer 140 and the LED mesa 120 have a same height (a height in the Z direction), and the light-emitting surface 124 is completely exposed to the outside. Then, the conductive spreading layer 130 is deposited on the light-emitting surface 124. In implementations of this application, the dielectric layer 140 covering the light-emitting surface 124 may be first removed according to the mechanical or chemical method, and then the conductive spreading layer 130 is processed.

In implementations of this application, the conductive spreading layer 130 may be made of a transparent conductive material, for example, indium tin oxide, zinc oxide, aluminum-doped zinc oxide, or fluorine-doped tin oxide. A thickness of the conductive spreading layer 130 may range from 10 nanometers to 500 nanometers.

In this application, a connection relationship between the light-emitting surface 124 of the LED mesa 120, the conductive spreading layer 130, and the dielectric layer 140 is set up, no dielectric layer 140 is left on the light-emitting surface 124, and the conductive spreading layer 130 is attached to the light-emitting surface 124. In addition, the conductive spreading layer 130 fully covers the light-emitting surface 124, there is no dielectric layer 140 between the conductive spreading layer 130 and the light-emitting surface 124, the entire light-emitting surface 124 is in contact with the conductive spreading layer 130, and the LED mesa 120 does not have the defect energy level formed by being in contacting with the dielectric layer 140. In addition, a carrier injection area of the LED mesa 120 can be maximized, and electrical-to-optical conversion efficiency of the display panel can be improved.

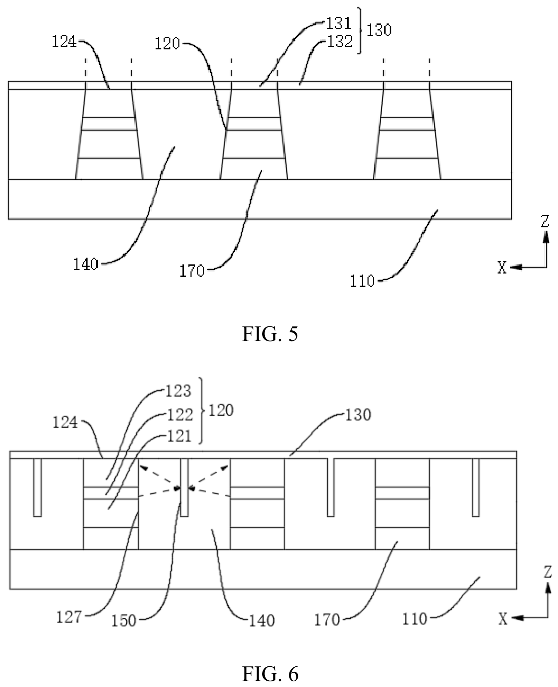

In some possible implementations, as shown in FIG. 5, the conductive spreading layer 130 in implementations of this application includes a first conductive part 131 and a second conductive part 132. The first conductive part 131 and the second conductive part 132 may be of an integrated structure. When the conductive spreading layer 130 is prepared, the first conductive part 131 and the second conductive part 132 are simultaneously formed by depositing a conductive film. In this implementation, the first conductive part 131 fully covers and is attached to the light-emitting surface 124, and the second conductive part 132 is attached to a side that is of the dielectric layer 140 and that is away from the substrate 110.

In implementations of this application, the first conductive part 131 of the conductive spreading layer 130 is attached to the light-emitting surface 124, the first conductive part 131 fully covers the light-emitting surface 124, the entire light-emitting surface 124 is in contact with the conductive spreading layer 130, the light-emitting surface 124 is not in contact with the dielectric layer 140, and there is no dielectric layer 140 between the light-emitting surface 124 and the conductive spreading layer 130. The light-emitting surface 124 does not have a defect energy level formed by being in contact with the dielectric layer 140. In this manner, the carrier injection area of the LED mesa 120 can be maximized, and electrical-to-optical conversion efficiency of the display panel can be improved.

In some possible implementations, as shown in FIG. 6, the display panel in implementations of this application further includes a reflective structure 150. The reflective structure 150 is located between the at least two adjacent LED mesas 120. Light emitted from the side surface 127 of the LED mesa 120 is reflected by the reflective structure 150 (refer to a dashed arrow in FIG. 6) and returned to the LED mesa 120.

In implementations of this application, an accommodation groove may be first etched in the dielectric layer 140, and a reflective layer is deposited in the accommodation groove, to form the reflective structure 150. The reflective structure 150 is vertically disposed between the at least two adjacent LED mesas 120, to reflect the light emitted from the side surface 127 of the LED mesa 120 back to the interior of the LED mesa 120. In a possible implementation, the reflective structure 150 extends in a direction perpendicular to an XZ plane, to form a structure like a reflective plate, and two side surfaces of the reflective plate in an X direction and an X reverse direction are reflective, so that second emitted light 126 emitted by LED mesas 120 on both sides of the reflective structure 150 in the X direction and the X reverse direction can be reflected by a same reflective structure 150.

In a possible implementation, the reflective structure 150 may be prepared by using the thin film deposition process, and a deposition thickness ranges from 100 nanometers to 2000 nanometers. The thickness is a thickness in the X direction in FIG. 6. A material of the reflective structure 150 may be a metal material with high reflectivity in a visible light wavelength range, including silver (Ag), aluminum (Al), titanium (Ti), and/or chromium (Cr).

In implementations of this application, the LED mesa 120 may emit photons when operating. A part of photons are emitted from the side surface 127 of the LED mesa 120, enter the dielectric layer 140, and reach the reflective structure 150. The reflective structure 150 may collect the photons emitted from the side surface 127 and reflect the photons to the LED mesa 120, to avoid a problem of optical crosstalk between different LED mesas 120 and improve electrical-to-optical conversion efficiency of the display panel.

When a spacing between adjacent LED mesas 120 is large, only one reflective structure 150 (for example, a reflective plate is vertically disposed between the adjacent LED mesas 120, as shown in FIG. 6) is disposed between the adjacent LED mesas 120. A spacing between the reflective structure 150 and the side surface 127 is large, and all or most of the light emitted from the side surface 127 of the LED mesa 120 cannot be reflected back to the interior of the LED mesa 120. Therefore, reflection efficiency of the reflective structure 150 is not high. Increasing a thickness of the reflective structure 150 in the X direction can reduce the spacing between the reflective structure 150 and the side surface 127.

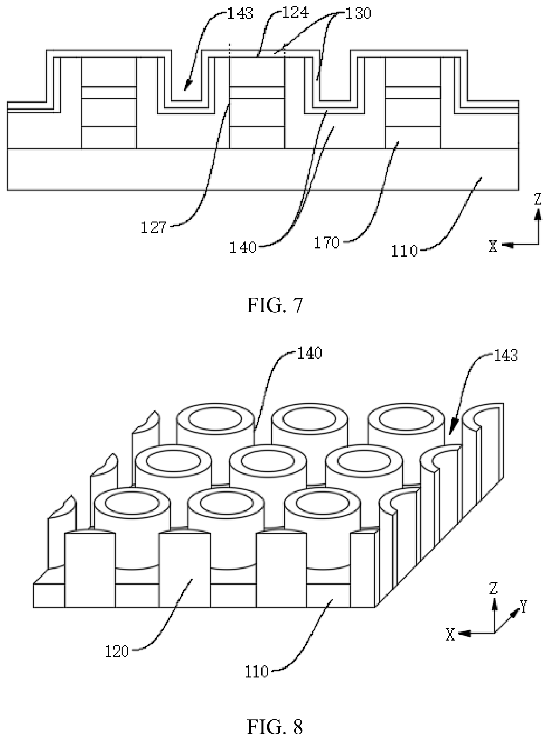

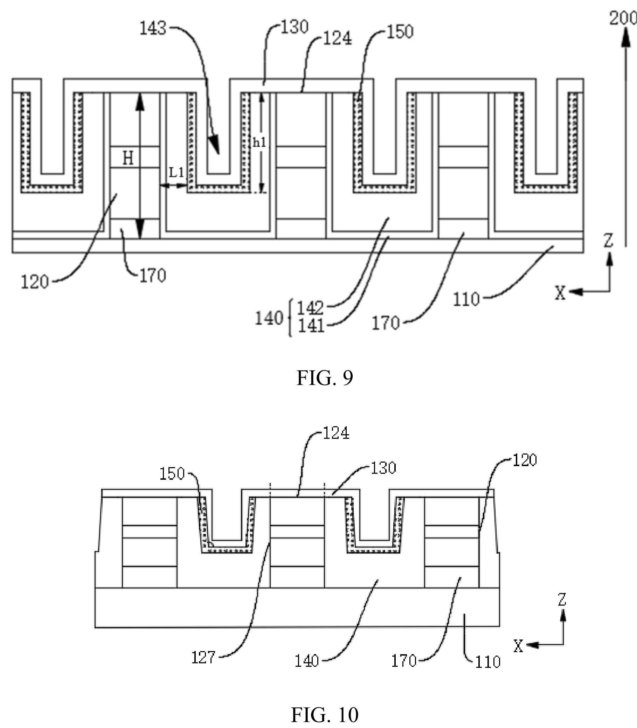

In some possible implementations, as shown in FIG. 7, a groove 143 may be formed in the dielectric layer 140, and the groove 143 is located on a part of the dielectric layer 140 between the at least two adjacent LED mesas 120. As shown in FIG. 9, the reflective structure 150 is located on an inner wall surface of the groove 143. The reflective structure 150 may be a reflective film attached to the inner wall surface of the groove 143, and the groove 143 may provide support for the reflective structure 150.

In this implementation, the groove 143 is disposed, and the reflective structure 150 is attached to the inner wall surface of the groove 143. A position relationship between the groove 143 and the LED mesa 120 may be adjusted, to adjust an angle at which the reflective structure 150 reflects the light emitted from the side surface 127 of the LED mesa 120, thereby improving reflection efficiency of the reflective structure 150.

FIG. 8 is a diagram of a structure of a part of the dielectric layer 140. On the display panel, grooves 143 between different LED mesas 120 are connected to form an irregular groove body. The groove 143 has a side wall on an outer side of each LED mesa 120. Distances between the side walls and the LED mesas 120 may be the same or different. Specifically, the groove 143 may be located at a middle position of adjacent LED mesas 120. A side wall that is of a groove 143 and that corresponds to a periphery of a single LED mesa 120 is at a same distance from the LED mesa 120 at each position, and a shape of the side wall that is of the groove 143 and that corresponds to the periphery of the LED mesa 120 is the same as a shape of the side wall of the LED mesa 120. Alternatively, in some possible cases, a side wall that is of a groove 143 and that corresponds to a periphery of a single LED mesa 120 may be at a different distance from the LED mesa 120 at a different position, and a shape of the side wall that is of the groove 143 and that corresponds to the periphery of the LED mesa 120 is different from a shape of the side wall of the LED mesa 120.

In an embodiment, distances between side walls that are of grooves 143 and that correspond to peripheries of different LED mesas 120 and the LED mesas 120 may be equal or unequal.

In some possible implementations, a first direction 200 in implementations of this application is a direction perpendicular to the substrate 110. As shown in FIG. 9, the first direction 200 is parallel to the Z direction in FIG. 9, the substrate 110 is a flat plate, and the first direction 200 is a direction perpendicular to a plane on which the substrate 110 is located. In the first direction 200, a length h1 of the reflective structure 150 is greater than or equal to 1/2 of a sum H of lengths of the LED mesa 120 and the bonding layer 170. In the first direction 200, the reflective structure 150 whose length is greater than or equal to 1/2 of the sum of the lengths of the LED mesa 120 and the bonding layer 170 may be used, so that the reflective structure 150 can collect the second emitted light emitted from the side surface of the LED mesa 120 and reflect the second emitted light back to the interior of the LED mesa 120, to enable the LED mesa 120 to emit light with more energy in the first direction 200, thereby improving electrical-to-optical conversion efficiency of the device.

In some possible implementations, the first direction 200 in implementations of this application is the direction perpendicular to the substrate 110. As shown in FIG. 9, the sum of the lengths of the LED mesa 120 and the bonding layer 170 in the first direction 200 is H, and a shortest distance between the reflective structure 150 and the LED mesa 120 is L1, where L1 is less than or equal to half of the length H.

In implementations of this application, the shortest distance L1 between the reflective structure 150 and the LED mesa 120 is less than or equal to half of the length H. It should be noted that, in the display panel provided in implementations of this application, a distance between the reflective structure 150 and the LED mesa 120 may be at a nanometer level. Affected by precision of a measurement instrument, a difference between a longest distance and a shortest distance between the reflective structure 150 and the LED mesa 120 may be small in a measurement result, considering factors such as a measurement error. In implementations of this application, the shortest distance between the reflective structure 150 and the LED mesa 120 is used as a limitation. The shortest distance between the reflective structure 150 and the LED mesa 120 is less than or equal to half of the length H. In this manner, the photons emitted from the side surface of the LED mesa 120 may pass through the dielectric layer 140 between the LED mesa 120 and the reflective structure 150, and reach the reflective structure 150. The reflective structure 150 reflects the photons back to the LED mesa 120, thereby avoiding the problem of optical crosstalk between different LED mesas 120 and improving optical-electrical conversion efficiency of the device.

In some possible implementations, as shown in FIG. 10, the reflective structure 150 in implementations of this application may be disposed obliquely relative to the side surface 127 of the LED mesa 120, and an included angle between a reflective surface of the reflective structure 150 and the substrate 110 is greater than or equal to 80 degrees.

When the included angle between the reflective surface of the reflective structure 150 and the substrate 110 increases, the shortest distance between the reflective structure 150 and the LED mesa 120 decreases accordingly. The reflective structure 150 is more likely to reflect the second emitted light emitted from the side surface 127 of the LED mesa 120 back to the interior of the LED mesa 120, thereby improving energy of the first emitted light emitted by the LED mesa 120 and improving electrical-to-optical conversion efficiency. In implementations of this application, the included angle between the reflective surface of the reflective structure 150 and the substrate 110 is greater than or equal to 80 degrees.

In some possible implementations, as shown in FIG. 9, the reflective structure 150 in implementations of this application may be made of a material whose visible light wavelength reflectivity is greater than or equal to 80%. In implementations of this application, the reflective structure 150 may be prepared by using the thin film deposition process, and the deposition thickness may range from 100 nanometers to 2000 nanometers. The deposition thickness is a spacing between an outer surface of the reflective structure 150 and the inner wall surface of the groove 143.

A metal material with high reflectivity in the visible light wavelength range may be selected as the material of the reflective structure 150, including silver, aluminum, titanium, chromium, and/or the like. A metal material with reflectivity greater than or equal to 80% may be preferentially selected. A metal material with visible light wavelength reflectivity greater than or equal to 80% may be used, to ensure a reflection effect of the reflective structure 150. When the photons emitted from the side surface of the LED mesa 120 are refracted by the dielectric layer 140 and reach the reflective structure 150, the reflective structure 150 may reflect the photons emitted from the side surface of the LED mesa 120 back to the LED mesa 120, thereby improving electrical-to-optical conversion efficiency of the display panel.

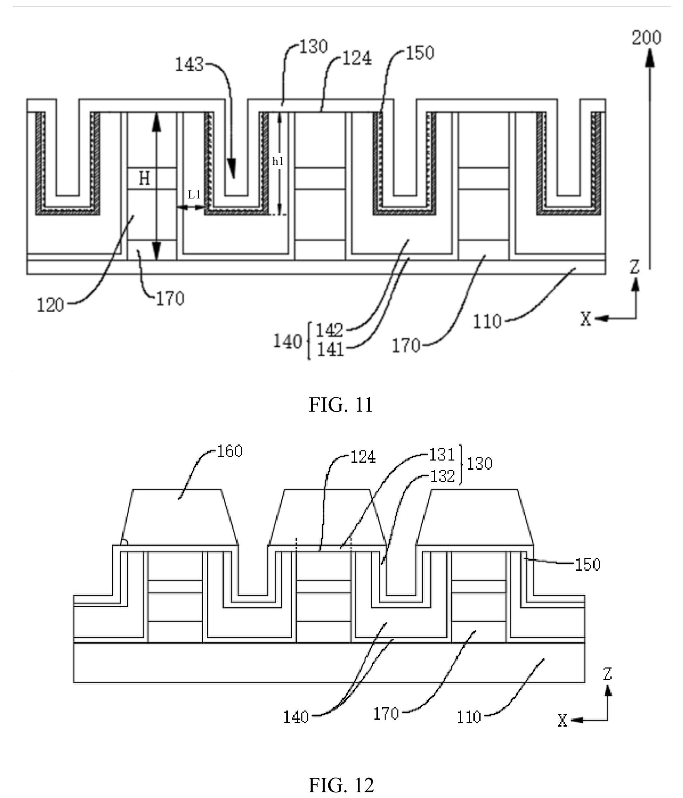

In some possible implementations, the reflective structure 150 in implementations of this application may include a plurality of reflective layers that are stacked to each other, where at least a part of the reflective layer is made of a metal material, and visible light wavelength reflectivity of at least one layer of the reflective structure 150 is greater than or equal to 80%. FIG. 11 shows two reflective layers as an example.

In implementations of this application, the reflective structure 150 may be a single metal material, or may be a composite film layer formed by combining a plurality of metal materials. When the reflective structure 150 is the composite film layer structure formed by combining the plurality of metal materials, visible light wavelength reflectivity of at least one layer of metal material in the composite film layer is greater than or equal to 80%.

One reflective layer is located between another reflective layer and the dielectric layer 140. Because the dielectric layer 140 is often made of an oxide or nitride material, a reflective layer that primarily serves a reflection function in the reflective structure 150 needs to be made of a metal material whose refractive index is greater than or equal to 80%. As a result, connection strength between the reflective layer and the dielectric layer 140 is insufficient. In this implementation, another reflective layer may be disposed between the reflective layer made of the metal material whose refractive index is greater than or equal to 80% and the dielectric layer 140. A refractive index of the reflective layer may be less than 80%, but the reflective layer has good connectivity with the dielectric layer 140 and the reflective layer whose refractive index is greater than or equal to 80%, to enhance structural strength of the display panel and improve a service life of the display panel.

In some possible implementations, a refractive index of the dielectric layer 140 in implementations of this application ranges from 1.4 to 2.2. The dielectric layer 140 may be prepared by using the thin film deposition process. The thickness of the deposited thin film may range from 5 nanometers to 5000 nanometers. A material for depositing a dielectric thin film may be silicon dioxide, aluminum oxide, silicon nitride, zirconium oxide, hafnium dioxide, titanium dioxide, aluminum nitride, silicon oxynitride, zinc oxide, or the like. A dielectric material with a refractive index ranging from 1.4 to 2.2 may be selected.

In some possible implementations, as shown in FIG. 9, the dielectric layer 140 in implementations of this application may include a first dielectric layer 141 and a second dielectric layer 142, and the first dielectric layer 141 is located between the LED mesa 120 and the second dielectric layer 142. A refractive index of the first dielectric layer 141 ranges from 1.6 to 2.2, and a refractive index of the second dielectric layer 142 ranges from 1.4 to 1.8.

In implementations of this application, the first dielectric layer 141 may be prepared by using the thin film deposition process. A dielectric material with a refractive index ranging from 1.6 to 2.2 is selected, and a thickness of a deposited thin film may range from 5 nanometers to 50 nanometers. A material for depositing the dielectric thin film may be silicon dioxide, aluminum oxide, silicon nitride, zirconium oxide, hafnium dioxide, titanium dioxide, aluminum nitride, silicon oxynitride, zinc oxide, or the like.

In implementations of this application, the second dielectric layer 142 may be prepared by using the thin film deposition process. A dielectric material with a refractive index ranging from 1.4 to 1.8 is selected, and a thickness of a deposited thin film may range from 5 nanometers to 5000 nanometers. A material for depositing the dielectric thin film may be silicon dioxide, aluminum oxide, silicon nitride, zirconium oxide, hafnium dioxide, titanium dioxide, aluminum nitride, silicon oxynitride, zinc oxide, or the like.

One side of the dielectric layer 140 is connected to the LED mesa 120, and the other side is connected to the reflective structure 150. The LED mesa 120 may be doped with different elements based on a material like GaN or GaAs, to form a light-emitting structure including a P-type semiconductor, a multiple quantum well layer, and an N-type semiconductor. The reflective structure 150 is often made of a metal material. In implementations of this application, two dielectric layers 140 are used. There is good connectivity between the first dielectric layer 141 and the second dielectric layer 142, there is good connection strength between the first dielectric layer 141 and the LED mesa 120, and there is good connection strength between the second dielectric layer 142 and the reflective structure 150. At least two dielectric layers 140 are disposed to implement connection transition, enhance structural strength of the display panel, and improve the service life of the display panel.

In some possible implementations, as shown in FIG. 12, the display panel in implementations of this application further includes a light-emitting structure 160. The light-emitting structure 160 is located on the side that is of the LED mesa 120 and that is away from the substrate 110. A part that is of the conductive spreading layer 130 and that is attached to the light-emitting surface 124 is the first conductive part 131, and the first conductive part 131 is located between the LED mesa 120 and the light-emitting structure 160.

In implementations of this application, the light-emitting structure 160 is located on the side that is of the LED mesa 120 and that is away from the substrate 110, and the conductive spreading layer 130 is separately connected to the LED mesa 120 and the light-emitting structure 160. The light-emitting structure 160 is located on a light-emitting side of the light-emitting surface 124, and can adjust a light-emitting angle after the display panel emits light.

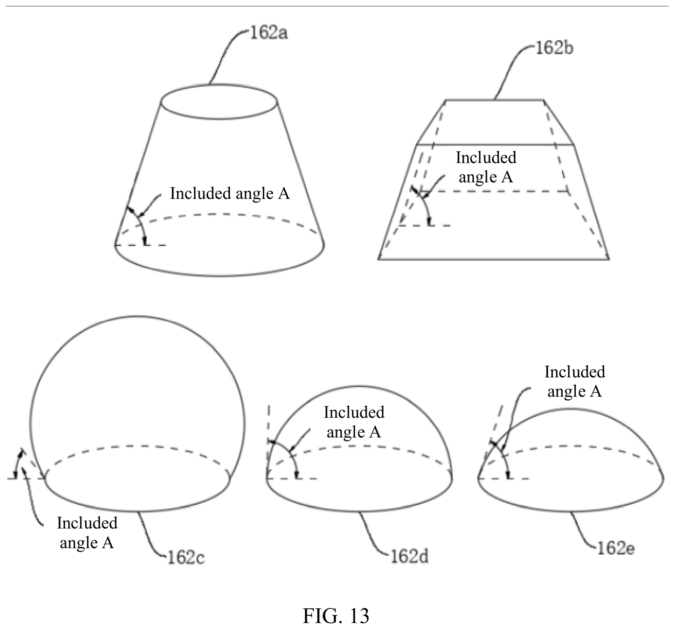

In a possible implementation, the light-emitting structure 160 may be a lens 162. A transparent material may be selected as a material of the lens 162, for example, transparent photoresist, silicon oxide, silicon nitride, or titanium oxide. As shown in FIG. 13, a shape of the lens 162 may be a frustum shape shown in a lens 162a, may be a prism shape shown in a lens 162b, may be a truncated spherical shape shown in a lens 162c (a sphere with a lower portion cut, where a cut surface is located below the center of the sphere), may be a hemispherical shape shown in a lens 162d (a sphere with a lower portion cut along a cut surface, where the cut surface coincides with the center of the sphere), may be a spherical cap shape shown in a lens 162e (a sphere with a lower portion cut, where a cut surface is located above the center of the sphere), or may be another lens shape. The lens 162 is configured to modulate a light-emitting angle, and can guide photons emitted from the light-emitting surface 124 to the first direction 200, to enhance forward light emission of the display panel.

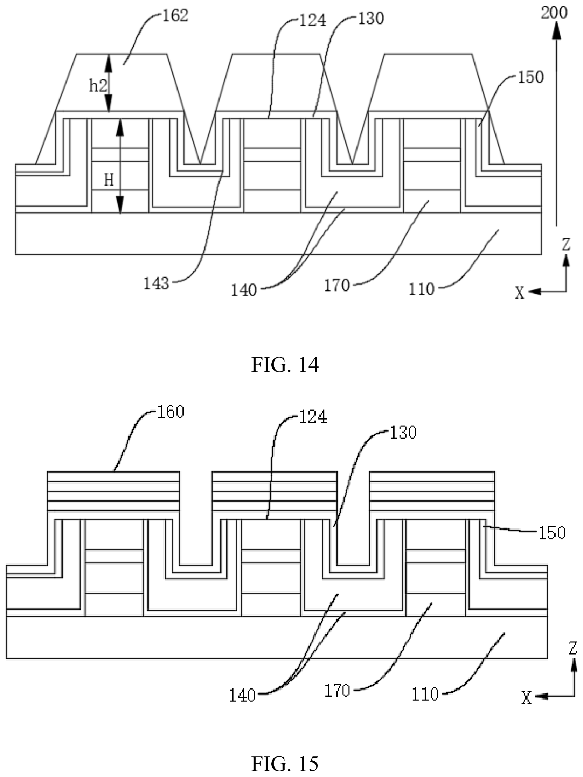

In some possible implementations, as shown in FIG. 14, the display panel in implementations of this application has the groove 143. Specifically, the groove 143 is located in the dielectric layer 140 between the at least two adjacent LED mesas 120, a part of the lens 162 extends into the groove 143, and the lens 162 is in contact with a bottom surface of the groove 143.

In implementations of this application, as shown in FIG. 14, the lens 162 is filled from the bottom of the groove 143. The shape of the lens 162 may be the frustum shape, the prism shape, the truncated spherical shape, the hemispherical shape, the spherical cap shape, or the like. In this embodiment, the prism shape is used as an example for description. A bottom surface of the lens 162 is coplanar with the bottom surface of the groove 143. The lens 162 fully covers the first conductive part 131. The photons emitted from the light-emitting surface 124 pass through the conductive spreading layer 130, and the photons are converged in the first direction 200 under the action of the lens 162, thereby enhancing forward light emission of the display panel in the first direction 200 and improving electrical-to-optical conversion efficiency of the display panel.

In some possible implementations, as shown in FIG. 13, the lens 162 in implementations of this application may be in the frustum shape, the prism shape, the truncated spherical shape, the hemispherical shape, the spherical cap shape, or the like. An included angle between a side surface of the lens 162 and the conductive spreading layer 130 at a contact position ranges from 60 degrees to 80 degrees.

As shown in FIG. 13, the side surface of the lens 162 may be spherical, arc-shaped, planar, or the like. An included angle A between the lens 162a and the conductive spreading layer 130 and an included angle A between the lens 162b and the conductive spreading layer 130 are included angles between a side wall of the lens 162 and the conductive spreading layer 130. An included angle A between the lens 162c and the conductive spreading layer 130, an included angle A between the lens 162d and the conductive spreading layer 130, and an included angle A between the lens 162e and the conductive spreading layer 130 are included angles between a tangent formed by junction between the side wall of the lens 162 and the conductive spreading layer 130 and the side wall of the lens 162 and the conductive spreading layer 130.

In this implementation, the lens 162 is located on the side that is of the LED mesa 120 and that is away from the substrate 110, the lens 162 is in contact with the conductive spreading layer 130, and the included angle between the side surface of the lens 162 and the conductive spreading layer 130 at the contact position ranges from 60 degrees to 80 degrees.

In some possible implementations, as shown in FIG. 14, the first direction 200 in implementations of this application is a direction perpendicular to the substrate 110, for example, a Z direction shown in FIG. 14. In the first direction 200, a length h2 of at least a part of the lens 162 on a side that is of the conductive spreading layer 130 and that is away from the substrate 110 is less than or equal to twice the sum H of the lengths of the LED mesa 120 and the bonding layer 170.

As shown in FIG. 14, the lens 162 may be entirely located on the conductive spreading layer 130, or may extend into the groove 143. In this implementation, the length h2 of the lens 162 above the conductive spreading layer 130 is limited to being less than or equal to twice the sum H of the lengths of the LED mesa 120 and the bonding layer 170. The lens 162 may adjust the light-emitting angle, and converge emitted light in a specific angle range.

In some possible implementations, as shown in FIG. 15, the light-emitting structure 160 in implementations of this application may be a Bragg reflector structure. Specifically, the Bragg reflector structure may be formed by sequentially stacking and depositing two types of thin films with different refractive indexes on the light-emitting structure 160. A refractive index of a low refractive index material ranges from 1.4 to 1.6, and a refractive index of a high refractive index material ranges from 2.2 to 2.8. For example, alternating deposition of a silicon dioxide thin film and a titanium dioxide thin film may be used.

In some possible implementations, a Bragg reflector in implementations of this application may be stacked and deposited in two layers by using two types of thin films with different refractive indexes, or may be sequentially stacked and deposited in more layers by using two types of thin films with different refractive indexes. The Bragg reflector that is sequentially stacked and deposited by using a plurality of layers of thin films with different refractive indexes may optimize a wavelength selection range.

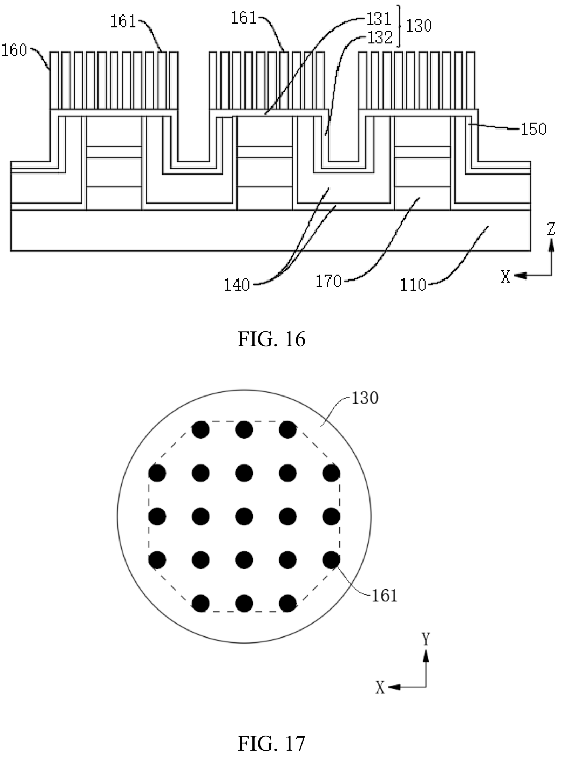

In some possible implementations, as shown in FIG. 16 to FIG. 18, the light-emitting structure 160 in implementations of this application may be a nanopillar array, and the nanopillar array is a combination formed by a plurality of nanopillars 161 arranged in a matrix. A cross section of the nanopillar 161 may be circular, square, regular hexagonal, or the like. As shown in FIG. 16, a nanopillar array structure is prepared on the first conductive part 131. A duty cycle of the nanopillar array structure may range from 20% to 70%. A ratio of a cross-sectional area of the nanopillar array in an XY plane direction (a Y direction in FIG. 16 is not shown) to an area enclosed by an external contour of a projection of the nanopillar array on the conductive spreading layer 130 ranges from 20% to 70% (as shown in FIG. 17, black dots in FIG. 17 are projections of the nanopillars 161 in a Z reverse direction on the conductive spreading layer 130 on which the nanopillars 161 are located, and the duty cycle is a ratio of a total area of all the black dots in FIG. 17 to an area enclosed by a dashed-line box). A diameter of a circular nanopillar may range from 1 nanometer to 1000 nanometers, a longest cross-sectional size of a non-circular nanopillar like a square nanopillar or a regular hexagonal nanopillar may range from 1 nanometer to 1000 nanometers, and a height of the nanopillar may range from 1 nanometer to 10 micrometers.

In some possible implementations, a material of the nanopillar may be gallium nitride (GaN), aluminum nitride (AlN), indium nitride (InN), ternary or quaternary alloys thereof (InₓGa₍₁₋ₓ₎N, AlₓGa₍₁₋ₓ₎N, and AlₓGa_{y}In_{(1-x-y)}P), zinc oxide (ZnO), silicon oxide (SiO₂), silicon nitride (Si₃N₄), titanium oxide (TiO₂), or the like.

In some possible implementations, in implementations of this application, the reflective structure 150 may reflect a part of photons emitted by the LED mesa 120 to the LED mesa 120, and the photons may enter the nanopillar array structure from the LED mesa 120. The light-emitting angle may be adjusted by using directionality of photon propagation in the nanopillar.

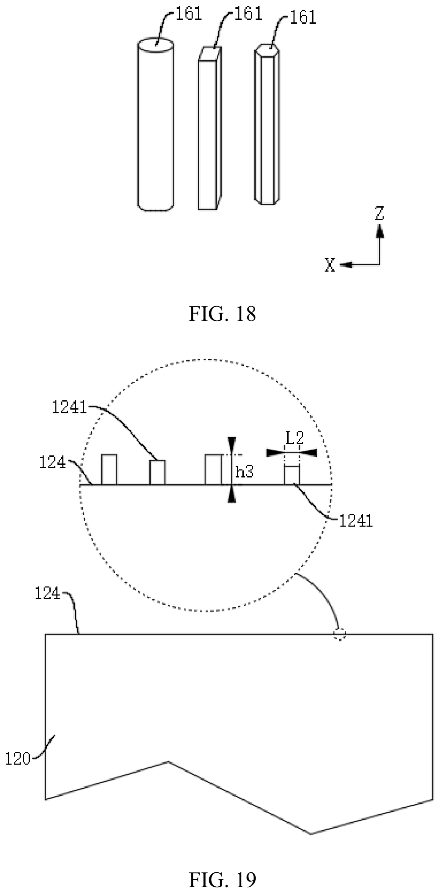

In some possible implementations, as shown in FIG. 19, in implementations of this application, the light-emitting surface 124 on the top of the LED mesa 120 is a micro-rough structure. Specifically, that the light-emitting surface 124 on the top of the LED mesa 120 is a rough structure means that the light-emitting surface 124 has a microstructure with convex and concave parts under a microstructure. It is mainly embodied in that, under display of a microscope like an optical microscope, an atomic force microscope, or a scanning electron microscope, the light-emitting surface 124 has a protrusion 1241. A height h3 of the protrusion 1241 in the Z direction ranges from 20 nanometers to 1000 nanometers, and a maximum width of the protrusion 1241 in the XY plane ranges from 20 nanometers to 500 nanometers.

In implementations of this application, a chemical corrosion method may be first used to roughen the light-emitting surface 124 of the top of the LED mesa 120, and then the conductive spreading layer 130 is deposited. The conductive spreading layer 130 may be made of the transparent conductive material, for example, indium tin oxide, zinc oxide, aluminum-doped zinc oxide, or fluorine-doped tin oxide. The thickness of the conductive spreading layer 130 may range from 10 nanometers to 500 nanometers.

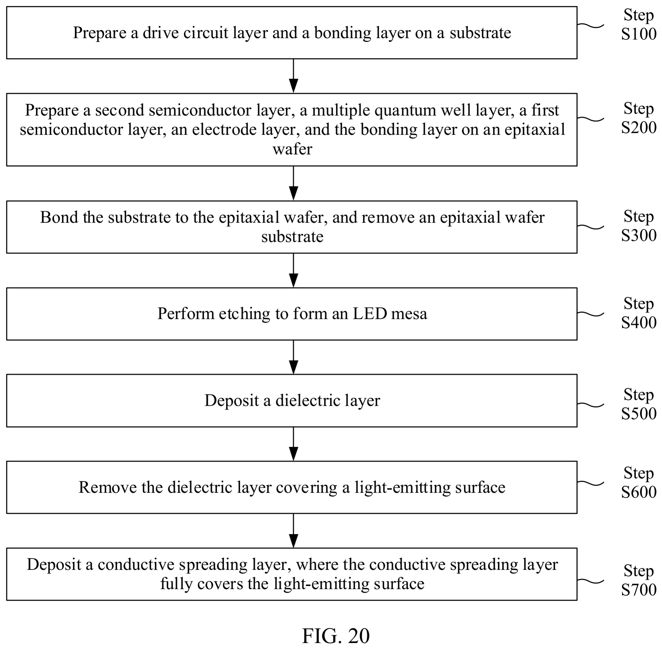

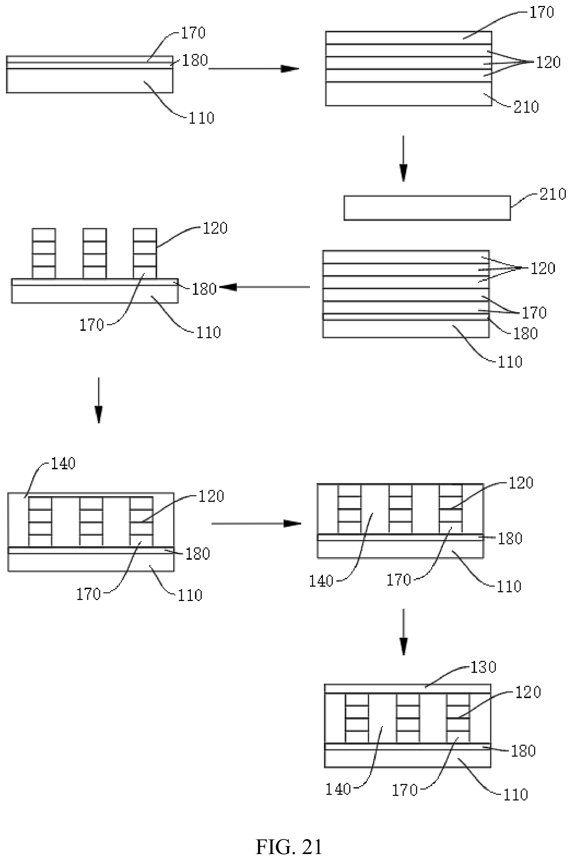

In some possible implementations, as shown in FIG. 20 and FIG. 21, the display panel provided in implementations of this application may be prepared according to the following method. The method includes the following steps.

Step S100: Prepare a drive circuit layer 180 and a bonding layer 170 on a substrate 110, where the drive circuit layer 180 is between the substrate 110 and the bonding layer 170.

Step S200: Prepare a second semiconductor layer, a multiple quantum well layer, a first semiconductor layer, an electrode layer, and the bonding layer 170 on an epitaxial wafer 210.

Step S300: Bond the substrate 110 to the epitaxial wafer 210, and remove an epitaxial wafer substrate.

Step S400: Perform patterned etching on a light-emitting pixel region according to a method like photolithography, to form an LED mesa 120, where a plurality of adjacent LED mesas 120 are formed on the substrate 110.

Step S500: Deposit a dielectric layer 140, where the dielectric layer 140 is deposited by using a thin film deposition process, and a thickness of a deposited thin film may range from 5 nanometers to 5000 nanometers.

Step S600: Process the dielectric layer 140 according to a mechanical or chemical method to remove the dielectric layer 140 covering a light-emitting surface 124, so that the dielectric layer 140 and the LED mesa 120 have a same height in a direction perpendicular to the substrate 110.

Step S700: Deposit a conductive spreading layer 130, where the conductive spreading layer 130 fully covers the light-emitting surface 124, the conductive spreading layer 130 is deposited by using the thin film deposition process, and a thickness of a deposited thin film ranges from 10 nanometers to 500 nanometers.

In a manufacturing process of a miniaturized display panel in a conventional technology, a dielectric film is deposited on a surface of a semiconductor. In this process, a part of a dielectric is left on the top of an LED mesa. The left dielectric may cover a part of a light-emitting surface 124, causing a decrease in a carrier injection area, and a defect energy level formed by being in contact with a dielectric film layer by the LED mesa, and reducing electrical-to-optical conversion efficiency of a device.

In implementations of this application, in step S600, the dielectric layer 140 on the light-emitting surface 124 is processed according to the mechanical or chemical method, to remove the dielectric layer 140 covering the light-emitting surface 124, so that the dielectric layer 140 and the LED mesa 120 have the same height (a height in a Z direction), and the light-emitting surface 124 is completely exposed to the outside. Then, the conductive spreading layer 130 is deposited on the light-emitting surface 124. The dielectric layer 140 is in contact with only a side surface 127 of the LED mesa 120, and the dielectric layer 140 does not exist between the conductive spreading layer 130 and the light-emitting surface 124. The conductive spreading layer 130 is attached to the light-emitting surface 124, and the light-emitting surface 124 is not in contact with the dielectric layer 140. The conductive spreading layer 130 fully covers the light-emitting surface 124, so that no energy level defect exists between the conductive spreading layer 130 and the light-emitting surface 124. In addition, a carrier injection area of the light-emitting surface 124 of the LED mesa 120 is increased, to increase electrical-to-optical conversion efficiency of the display panel.

In some possible implementations, in step S100 and step S200, a material for manufacturing the bonding layer 170 may include a conductive material and a non-conductive material. For example, the conductive material may be one or more of gold, tin, indium, copper, titanium, nickel, aluminum, platinum, or tantalum. The non-conductive material may be one or more of polyimide, polydimethylsiloxane, photoresist, hydrogen silsesquioxane, and divinylsiloxane-bis-benzocyclobutene. Alternatively, the non-conductive material may be a metal oxide or a metal nitride, for example, one or more of aluminum oxide, aluminum nitride, titanium oxide, and titanium nitride.

In some possible implementations, in step S500, the dielectric layer 140 may be prepared by using a material whose refractive index ranges from 1.4 to 2.2. For example, a dielectric material may be at least one of SiO₂, Al₂O₃, SiNₓ, ZrO₃, HfO₂, TiO₂, AlN, SiON, and ZnO₂.

In some possible implementations, in step S700, the conductive spreading layer 130 may be prepared by using a transparent conductive material, for example, indium tin oxide, zinc oxide, aluminum-doped zinc oxide, or fluorine-doped tin oxide. A thickness of a deposited thin film is 10 nanometers to 500 nanometers.

In some possible implementations, in step S500, preparing the dielectric layer 140 may include two steps, that is, preparing a first dielectric layer 141 and preparing a second dielectric layer 142.

In implementations of this application, the first dielectric layer 141 may be prepared by using the thin film deposition process. A dielectric material with a refractive index ranging from 1.6 to 2.2 is selected, and a thickness of a deposited thin film may range from 5 nanometers to 50 nanometers. A material for depositing a dielectric thin film may be silicon dioxide, aluminum oxide, silicon nitride, zirconium oxide, hafnium dioxide, titanium dioxide, aluminum nitride, silicon oxynitride, zinc oxide, or the like.

In implementations of this application, the second dielectric layer 142 may be prepared by using the thin film deposition process. A dielectric material with a refractive index ranging from 1.4 to 1.8 is selected, and a thickness of a deposited thin film ranges from 5 nanometers to 5000 nanometers. A material for depositing a dielectric thin film may be silicon dioxide, aluminum oxide, silicon nitride, zirconium oxide, hafnium dioxide, titanium dioxide, aluminum nitride, silicon oxynitride, zinc oxide, or the like.

In implementations of this application, one side of the dielectric layer 140 is connected to the LED mesa 120, and the other side is connected to a reflective structure 150. The LED mesa 120 may be made of gallium nitride, and the reflective structure 150 may be made of a metal material. Two dielectric layers 140 are prepared. There is good connectivity between the first dielectric layer 141 and the second dielectric layer 142, there is good connection strength between the first dielectric layer 141 and the LED mesa 120, and there is good connection strength between the second dielectric layer 142 and the reflective structure 150. At least two dielectric layers 140 are prepared to implement connection transition, enhance structural strength of the display panel, and improve a service life of the display panel.

In some possible implementations, in step S500, an accommodation groove may be further etched in the dielectric layer 140, and a reflective layer is deposited in the accommodation groove, to form the reflective structure 150. The reflective structure 150 is vertically disposed between at least two adjacent LED mesas 120, and can reflect light emitted from the side surface 127 of the LED mesa 120 back to the interior of the LED mesa 120.

In some possible implementations, the reflective structure 150 may be prepared by using the thin film deposition process, and a deposition thickness ranges from 100 nanometers to 2000 nanometers. The thickness is a thickness shown in an X direction in FIG. 6. A material of the reflective structure 150 may be a metal material with high reflectivity in a visible light wavelength range, including silver (Ag), aluminum (Al), titanium (Ti), and/or chromium (Cr).

In implementations of this application, the LED mesa 120 may emit photons when operating. A part of photons are emitted from the side surface 127 of the LED mesa 120, enter the dielectric layer 140, and reach the reflective structure 150. The reflective structure 150 may collect the photons emitted from the side surface 127 and reflect the photons to the LED mesa 120, to avoid a problem of optical crosstalk between different LED mesas 120 and improve electrical-to-optical conversion efficiency of the display panel.

In some possible implementations, in step S500, a groove 143 may be further prepared in the dielectric layer 140. Specifically, the groove 143 is prepared in a part of the dielectric layer 140 between the at least two adjacent LED mesas 120, and then the reflective structure 150 is prepared on an inner wall surface of the groove 143. The groove 143 may provide support for the reflective structure 150.

In this implementation, the groove 143 is prepared, and the reflective structure 150 is prepared on the inner wall surface of the groove 143. A position relationship between the groove 143 and the LED mesa 120 may be adjusted, to adjust an angle at which the reflective structure 150 reflects light emitted from the side surface 127 of the LED mesa 120, thereby improving reflection efficiency of the reflective structure 150.

In some possible implementations, a first direction 200 in implementations of this application is a direction perpendicular to the substrate 110, the substrate 110 is a flat plate, and the first direction 200 is a direction perpendicular to a plane on which the substrate 110 is located. As shown in FIG. 9, in the first direction 200, a length h1 of the prepared reflective structure 150 is greater than or equal to 1/2 of a sum H of lengths of the LED mesa 120 and the bonding layer 170. The reflective structure 150 whose length in the first direction 200 is greater than or equal to 1/2 of the sum of the lengths of the LED mesa 120 and the bonding layer 170 may be prepared, so that the reflective structure 150 can collect second emitted light emitted from the side surface of the LED mesa 120 and reflect the second emitted light back to the interior of the LED mesa 120, to enable the LED mesa 120 to emit light with more energy in the first direction 200, thereby improving electrical-to-optical conversion efficiency of the device.

In some possible implementations, the method for manufacturing the display panel provided in implementations of this application may further include the following step.

Step S800: Prepare a light-emitting structure 160, where the light-emitting structure 160 is prepared on a side that is of the conductive spreading layer 130 and that is away from the substrate 110.

In some possible implementations, in step S800, the prepared light-emitting structure 160 may be a lens 162. A transparent material may be selected as a material of the lens 162, for example, transparent photoresist, silicon oxide, silicon nitride, or titanium oxide. A shape of the lens 162 may be a frustum shape, a prism shape, a truncated spherical shape, a spherical cap shape, or the like shown in FIG. 13. The lens 162 can modulate a light-emitting angle, and can guide photons emitted from the light-emitting surface 124 to the first direction 200, to enhance forward light emission of the display panel.

In some possible implementations, in step S800, the prepared lens 162 may be filled from the bottom of the groove 143. The shape of the lens 162 may be the frustum shape, the prism shape, the truncated spherical shape, the hemispherical shape, the spherical cap shape, or the like shown in FIG. 13. In this embodiment, the prism shape is used as an example for description. As shown in FIG. 14, a bottom surface of the prepared lens 162 is coplanar with a bottom surface of the groove 143. The lens 162 fully covers a first conductive part 131. The photons emitted from the light-emitting surface 124 pass through the conductive spreading layer 130, and the photons are converged in the first direction 200 under the action of the lens 162, thereby enhancing forward light emission of the display panel in the first direction 200 and improving electrical-to-optical conversion efficiency of the display panel.

In some possible implementations, an implementation of this application provides an electronic device. The electronic device includes the display panel in the foregoing implementations. Specifically, the electronic device may be an electronic device that can be used for image display, for example, augmented reality (augmented reality, AR) glasses, virtual reality (virtual reality, VR) glasses, a smartphone, a tablet computer, a smartwatch, or a dashcam.

In some possible implementations, in implementations of this application, an example in which the electronic device is AR glasses is used to describe technical solutions of this application in detail. The AR glasses are smart link devices between the virtual world and the real world. With the AR glasses, the real world and virtual content can be seen, and information interaction such as visual and auditory interaction can be performed. The AR glasses can superimpose virtual information on the real world by using computer technologies, so that the real environment and a virtual object can be superimposed on a same picture in real time, to implement mutual supplementation of the two types of information and perform information interaction such as visual and auditory interaction.

In implementations of this application, the AR glasses include the display panel and a glasses frame. The display panel is fastened to the glasses frame. Specifically, the display panel may be installed in a glasses leg of the AR glasses. The display panel can display a picture, and display the picture in front of a user by using a device like glasses, to enhance a sense of reality of the user.

The foregoing embodiments are merely intended for describing the technical solutions of this application, but not for limiting this application. Although this application is described in detail with reference to the foregoing embodiments, a person of ordinary skill in the art should understand that modifications may still be made to the technical solutions described in the foregoing embodiments or equivalent replacements may be made to some technical features thereof, without departing from the spirit and scope of the technical solutions of embodiments of this application, and these modifications and replacements shall fall within the protection scope of this application.

## Claims

1. A display panel, comprising a substrate, and an LED mesa and a conductive spreading layer that are located on the substrate, wherein the LED mesa comprises a light-emitting surface, the light-emitting surface is used for emission of light from the display panel, and the conductive spreading layer is attached to and fully covers the light-emitting surface.

2. The display panel according to claim 1, wherein there are a plurality of LED mesas, the plurality of LED mesas are spaced apart on the substrate, the display panel further comprises a reflective structure, and the reflective structure is located between adjacent LED mesas and is configured to reflect light emitted from a side surface of the LED mesa back to the LED mesa.

3. The display panel according to claim 2, wherein the display panel further comprises a dielectric layer, the dielectric layer is filled between the adjacent LED mesas, the dielectric layer has a groove, and the reflective structure is located in the groove.

4. The display panel according to claim 2 or 3, wherein the display panel further comprises a bonding layer, and the bonding layer is located between the LED mesa and the substrate; and
a first direction is a direction perpendicular to the substrate, a length of the reflective structure in the first direction is greater than or equal to 1/2 of a sum of lengths of the LED mesa and the bonding layer in the first direction, and/or a shortest distance between the reflective structure and the LED mesa is less than or equal to 1/2 of the sum of the lengths of the LED mesa and the bonding layer in the first direction.

5. The display panel according to any one of claims 2 to 4, wherein an included angle between a reflective surface of the reflective structure and the substrate is greater than or equal to 80 degrees.

6. The display panel according to any one of claims 2 to 5, wherein visible light reflectivity of the reflective structure is greater than or equal to 80%.

7. The display panel according to any one of claims 2 to 6, wherein the reflective structure comprises a plurality of reflective layers that are stacked to each other, and visible light reflectivity of at least one of the reflective layers is greater than or equal to 80%.

8. The display panel according to any one of claims 1 to 7, wherein a refractive index of the dielectric layer ranges from 1.4 to 2.2.

9. The display panel according to any one of claims 1 to 8, wherein the dielectric layer comprises a first dielectric layer and a second dielectric layer, the first dielectric layer is located between the LED mesa and the second dielectric layer, a refractive index of the first dielectric layer ranges from 1.6 to 2.2, and a refractive index of the second dielectric layer ranges from 1.4 to 1.8.

10. The display panel according to any one of claims 1 to 9, wherein the LED mesa comprises a first semiconductor layer, a multiple quantum well layer, and a second semiconductor layer that are sequentially stacked, and the first semiconductor layer is located between the multiple quantum well layer and the substrate.

11. The display panel according to any one of claims 1 to 10, wherein the conductive spreading layer comprises a first conductive part and a second conductive part, the first conductive part is attached to and fully covers the light-emitting surface, and the second conductive part is attached to the dielectric layer.

12. The display panel according to any one of claims 1 to 11, wherein the display panel further comprises a light-emitting structure, a part that is of the conductive spreading layer and that is attached to the light-emitting surface is the first conductive part, and the light-emitting structure is disposed on the first conductive part and is configured to change a direction of light emitted from the light-emitting surface.

13. The display panel according to claim 12, wherein the display panel further comprises the dielectric layer, the dielectric layer is filled between the adjacent LED mesas, the dielectric layer has the groove, the light-emitting structure comprises a lens, and the lens partially extends into the groove.

14. The display panel according to claim 12 or 13, wherein the light-emitting structure comprises the lens, the lens is in a frustum shape, a spherical shape, or a prism shape, and an included angle between a side surface of the lens and the conductive spreading layer at a contact position is within a range of 60 degrees to 80 degrees.

15. The display panel according to any one of claims 12 to 14, wherein the display panel further comprises the bonding layer, the bonding layer is located between the LED mesa and the substrate, the first direction is a direction that is perpendicular to the substrate and in which the substrate faces the LED mesa, and a length of at least a part of the light-emitting structure on one side of the conductive spreading layer in the first direction is less than or equal to twice the sum of the lengths of the LED mesa and the bonding layer in the first direction.

16. An electronic device, comprising the display panel according to any one of claims 1 to 15.
